Europäisches Patentamt

European Patent Office

Office européen des brevets

(19)

(11) Publication number: **0 327 210**
**A1**

# EUROPEAN PATENT APPLICATION

(12)

(21) Application number: **89300320.2**

(22) Date of filing: **13.01.89**

(51) Int. Cl.⁴: **H01L 21/285 , H01L 21/60 , H01L 21/90**

(30) Priority: **20.01.88 US 146008**

(43) Date of publication of application:
**09.08.89 Bulletin 89/32**

(84) Designated Contracting States:
**AT BE CH DE ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Wang, Hsingya Arthur**
**2698 Keppler Drive**
**San Jose California 95148(US)**
Inventor: **Miu, Kenneth Vai-Kun**
**3015 Balboa Street**
**San Francisco California 94121(US)**
Inventor: **Nallamothu, Sucheta**
**10413 Glenview Avenue**
**Cupertino California 95014(US)**

(74) Representative: **Wright, Hugh Ronald et al**
**Brookes & Martin 52/54 High Holborn**
**London WC1V 6SE(GB)**

(54) **Method of preventing silicide peel-off.**

(57) A method of preventing silicide peel-off uses rapid thermal processing to uniformly distribute the constituents of a silicide after the silicide has been subjected to a processing step which causes the silicide to become metal-rich at its exposed surfaces and prior to an oxidation step. Uniformly distribution the constituents of the silicide prevents the formation of metal oxide during the oxidation step, thereby eliminating the deformation of the silicide layer which is a major cause of peel-off. This method is particularly useful in the fabrication of dual layer, polysilicon/silicide gates for field-effect transistors, where the etching step used to pattern the gate removes polysilicon from the silicide faster than the metal is removed, and thus causes the surface of the silicide to be metal-rich.

# METHOD OF PREVENTING SILICIDE PEEL-OFF

The present invention relates to the fabrication of semiconductor devices; more particularly, to the fabrication of layers of metal-semiconductor compounds in semiconductor devices.

Metal-semiconductor compounds, e.g., silicides, have been used to decrease the resistivity of gates and interconnects in semiconductor devices by, for example, providing a metal-semiconductor layer over a polysilicon layer in the formation of gates for field-effect transistors. The benefits of such decreases in resistivity are discussed in Refractory Silicides of Titanium and Tantalum for Low-Resistivity Gates and Interconnects by Murarka et al, IEEE Journal of Solid-State Circuits Vol. SC-15, No. 4, August 1980. However, in the formation of conventional field-effect transistors, metal-semiconductor compound layers formed over the polysilicon layers have a tendency to peel-off of the polysilicon. Metal-semiconductor compound (silicide) peel-off, which occurs during processing steps subsequent to the formation of a metal-semiconductor layer, is a severe problem causing the wafers affected by peel-off to be scrapped; further, the equipment utilized to process the wafers effected by peel-off must be cleaned.

Dual layers of polysilicon and silicide are used instead of a gate formed solely of a silicide to maintain the well-known electrical and physical properties of polysilicon gate field-effect transistors (FETs). Thus, a dual layer gate structure can be retrofit into existing product designs; on the other hand, silicide gate FETs would require further changes in product design. The known characteristics of polysilicon gate FETs are maintained by providing a polysilicon gate having at least one (1) atomic layer of polysilicon.

The formation of an FET including a dual layer (polysilicon/silicide) gate includes the steps of forming a gate oxide on the surface of a substrate, providing a polysilicon layer on the gate oxide, and providing a silicide layer on the polysilicon layer. The polysilicon and silicide layers are masked and etched to provide a gate structure of a desired pattern. The next step in processing is to grow a thermal oxide at the surface of the substrate, the thermal oxide being used to protect the substrate during the ion implantation which creates the source and drain regions. The thermal oxide is grown to a thickness of between 50 and 1000 Angstroms by subjecting the device to high-temperatures in a wet or dry oxygen ambient. However, subjecting the silicide to a high temperature in an oxygen-containing ambient to grow the thermal oxide causes silicide peel-off.

We will describe a method of fabricating a field-effect transistor having a polysilicon/silicide gate structure which alleviates silicide peel-off.

We will describe a method to prevent peel-off of and any metal-semiconductor compound layer utilized in a semiconductor device.

A silicide layer becomes metal-rich at its exposed surfaces when an etching process is used to define the shape of the silicide layer because the etchants used for such purposes tend to etch silicon faster than metal. The metal-rich condition enables metal oxide to form on the silicide. Although silicon oxidizes much more readily than metal, if there is no silicon available at the surface of the silicide to be oxidized, the metal in the silicide is oxidized. The formation of a metal oxide, which has a large volume, deforms the gate material and is one cause of silicide peel-off.

To prevent silicide peel-off, we will describe a method which adds, to the conventional fabrication process, the step of uniformly distributing, or homogenizing, the composition of the silicide, thereby preventing the formation of metal oxide at the surface of the silicide. The added processing step which provides a uniform distribution of the constituents of the metal-semiconductor compound is an annealing step, preferably rapid thermal processing (RTP). The annealing should be performed over a relatively short period of time, for example, two (2) minutes or less, to prevent damage to other devices formed on the same die and to prevent diffusion of the compensation implant in the substrate. This annealing or RTP step is performed after the silicide is exposed to a process which creates a metal-rich condition at the exposed surfaces of the silicide and before the device is subject to an oxidizing environment.

The method of the present invention may include the steps of providing a metal-semiconductor compound layer in the fabrication of a semiconductor device, and treating the metal-semiconductor compound layer to uniformly distribute the constituents thereof after a processing step which leaves the metal semiconductor compound metal rich at its exposed surface(s) and prior to oxidizing the semiconductor device during subsequent processing.

## BRIEF DESCRIPTION OF THE DRAWINGS

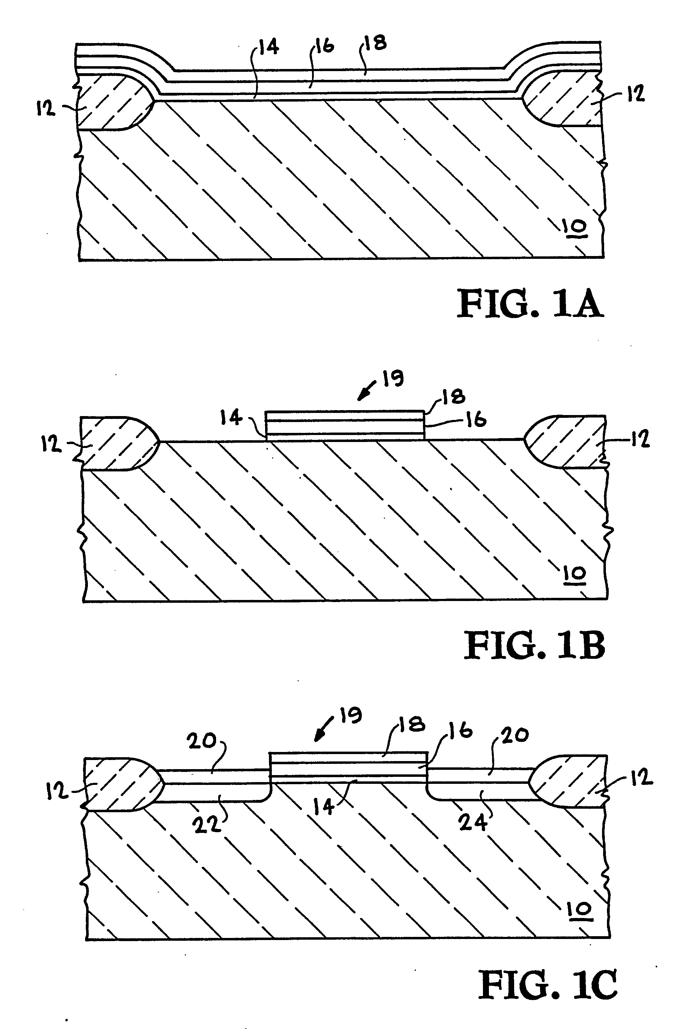

Figs. 1A-C are cross-sectional views of a field-effect transistor showing the various steps in the fabrication of the field effect transistor.

## DESCRIPTION OF THE PREFERRED EMBODIMENT

It has been discovered, by the inventors of the present invention, that the etching process utilized in removing portions of a layer of a metal-semiconductor compound causes the exposed surfaces of the metal-semiconductor compound to become metal-rich. Specifically, the etching process removes silicon faster than metal. Subjecting a metal-semiconductor compound which is metal-rich at its exposed surface to oxidation causes the formation of metal oxide at the exposed surfaces of the metal-semiconductor compound.

The formation of metal oxide at the exposed surfaces of the metal-semiconductor compound deforms the layer of metal-semiconductor compound. A deformation occurs because of the low density of the metal oxide, and thus the large increase in the volume of a metal which is oxidized. For example, silicon oxide ($SiO_2$) is 100 times more dense than most metal oxides at the oxidation temperature.

Peel-off is related both to the structural deformation caused by the large volume of metal oxides and by the high vapor pressure of the metal oxides during oxidation. The vapor pressure is on the order of 0.1 atmospheres at 700° C to 1100° C and results in a breakup of the metal oxide being formed, and thus a breakup or peel-off of the silicide layer itself.

The peel-off problem is common to most metal-semiconductor compounds which are subject to oxidation and after a treatment or process, e.g., etching, which creates a metal-rich condition at the surface of the metal-semiconductor compound.

In the preferred embodiment of the present invention the metal-semiconductor compound is a silicide provided on a polysilicon gate in a field-effect transistor. The silicide may be a tungsten or molybdenum silicide. However, the present invention is applicable to other silicides, for example, titanium and tantalum silicides, as well as other metalsemiconductor compounds including different semiconductors and different metals. Further, the present invention is not limited to the formation of field-effect transistors and may be applied to any other type of device which utilizes a metal-semiconductor compound layer.

A method of fabricating a field-effect transistor in accordance with the method of the present invention will be described with reference to Figs. 1A-C. As shown in Fig. 1A, a substrate 10 has field oxide regions 12 which define the region where a field-effect transistor is to be fabricated. A gate oxide 14 is provided on the surface of the substrate, and, if desired, a compensation implant is performed through the gate oxide 14. A polysilicon layer 16 is provided on the gate oxide 14 and a silicide layer 18 is provided on polysilicon layer 16. A mask (not shown) is provided on the silicide layer 18 and the device is then etched to provide a gate structure 19 as shown in Fig. 1B. The etching step leaves the silicide layer 18 with a metal-rich condition at its exposed surfaces.

To alleviate the metal-rich condition at the exposed surface of the silicide, an additional method step of annealing, or rapid thermally processing, the device is used to uniformly distribute the constituents of silicide layer 18. The redistribution of the constituents of silicide layer 18, which is also referred to as homogenization, prevents the formation of metal oxide at the exposed surfaces of silicide layer 18 by alleviating the condition where silicide layer 18 is metal-rich at its exposed surfaces. Thus, a supply of silicon is available at the exposed surfaces for oxidation.

Oxygen combines with silicon much more readily than with a metal, and thus if there is a ready supply of silicon at the exposed surfaces of silicide layer 18 the metal in the silicide will not be consumed during oxidation. If there is a deficiency in the supply of silicon, peel-off will not be prevented because the oxygen will combine with the metal in the silicide to create metal oxide.

To homogenize, or provide a uniform distribution of the constituents of silicide layer 18, the device is subject to a relatively short anneal or RTP cycle. To prevent other devices formed on the same substrate from being damaged, and to prevent the compensation implant which is provided into the substrate through the gate oxide layer prior to the formation of the gate structure from being defused, the annealing cycle should be less than approximately two (2) minutes. The anneal or RTP is performed in an inert atmosphere, preferably nitrogen ($N_2$) or argon (Ar). The wafer is rapidly heated from room temperature to a treatment temperature of approximately 800° C to 1100° C, the duration of the rapid thermal processing depending on the processing temperature. For example, the processing time is approximately two (2) seconds at a temperature of approximately 1100° C and approximately twenty (20) seconds at a temperature of approximately 800° C.

After silicide layer 20 has been homogenized a thermal oxide layer 20 (Fig. 1c) is grown at the surface of the substrate (if the gate oxide layer 14 is not completely removed, thermal oxide layer 20 grows at the interface of the gate oxide layer 14 and substrate 10). Subsequently, source and drain regions 22, 24 are implanted in substrate 10 through thermal oxide 20. Device fabrication is completed using conventional techniques, silicide peel-off having been prevented.

## Claims

A method of preventing peel-off of a silicide layer in a semiconductor device, comprising the steps of:

(a) providing a silicide layer in the semiconductor device;

(b) subjecting the semiconductor device to a treatment which causes the silicide layer to be metal-rich at its exposed surfaces; and

(c) treating tha silicide layer to uniformly distribute the constituents thereof.

2. A method according to claim 1, wherein said step (b) comprises etching the silicide and said step (c) comprises rapid thermally processing the silicide layer.

3. A method according to claim 2, wherein said step (c) comprises rapid thermally processing for approximately 2-120 seconds at a temperature range of approximately 800-1100° C.

4. A method according to claim 2, wherein said step (c) comprises rapid thermally processing for approximately 30 seconds at approximately 900° C.

5. A method according to claim 3, wherein said step (a) comprises providing a silicide layer on a polysilicon layer and said step (b) comprises etching the polysilicon layer and the silicide layer to provide a gate for a field-effect transistor.

6. A method according to claim 5, further comprising the step (d) of oxidizing the semiconductor device after said step (c).

7. A method of preventing the formation of metal oxide at the surface of a metal-semiconductor compound layer during a process of fabricating a semiconductor device which causes the exposed surfaces of the metal-semiconductor compound to be metal-rich, comprising the step of:
treating the metal-semiconductor compound layer to uniformly distribute the constituents thereof.

8. A method according to claim 7, wherein said step comprises annealing the semiconductor device.

9. A method according to claim 7, wherein said step comprises rapid thermally processing (RTP) the semiconductor device.

10. A method according to claim 7, wherein said step comprises RTP for less than one (1) minute.

11. A method of fabricating a gate structure for an field-effect transistor provided on a substrate, comprising the steps of:

(a) providing a gate oxide on the substrate;

(b) providing a gate on the gate oxide;

(c) providing a layer of a metal-semiconductor compound on the gate;

(d) subjecting the field-effect transistor to a process which causes the metal-semiconductor compound to be metal-rich at its exposed surfaces; and

(e) treating the metal-semiconductor compound layer to homogenize the constituents of the metal-semiconductor compound after said step (d).

12. A method according to claim 11, wherein said step (c) comprises providing a layer of a metal-semiconductor compound having a lower resistivity than the gate.

13. A method according to claim 11, wherein said step (c) comprises providing a layer of a silicide.

14. A method according to claim 11, wherein said step (b) comprises providing a doped polysilicon layer having a thickness of at least one (1) atomic layer.

15. A method according to claim 12, wherein said step (e) comprises annealing the layer of metal-semiconductor compound to provide a uniform distribution of the metal and the semiconductor.

16. A method according to claim 15, wherein said step (e) comprises rapid thermal processing of the layer of metal-semiconductor compound.

17. A method according to claim 16, wherein said step (e) comprises heating the layer of metal-semiconductor compound in an inert ambient for approximately 2-120 seconds at a temperature range of approximately 800-1100° C.

18. A method according to claim 16, wherein said step (e) comprises heating the layer of metal-semiconductor compound in an inert ambient for approximately 30 seconds at approximately 900° C.

19. A method of fabricating a gate structure for a semiconductor device formed on a substrate, comprising the steps of:

(a) providing a gate oxide on the substrate;

(b) providing a polysilicon layer on the gate oxide;

(c) providing a silicide layer on the polysilicon layer;

(d) patterning the polysilicon layer and the silicide layers with an etchant, thereby causing the silicide to be metal-rich at its exposed surfaces: and

(e) rapid thermally processing the silicide layer to provide a uniform distribution of the metal and the polysilicon in the silicide.

20. A method according to claim 19, wherein said step (c) comprises providing a refractory metal silicide layer.

21. A method according to claim 19, wherein said step (c) comprises providing a tungsten silicide layer.

22. A method according to claim 19, wherein said step (c) comprises providing a molybdenum silicide layer.

23. A method according to claim 19, wherein said step (e) comprises thermally processing the silicide layer in an inert atmosphere for approximately 2-120 seconds at a temperature range of approximately 800-1100°C.

24. A method acoording to claim 19, wherein said step (d) comprises thermally processing the silicide layer in an inert atmosphere for approximately 30 seconds at approximately 900°C.

25. A method of fabricating a field-effect transistor on a substrate, comprising the steps of:

(a) providing a gate oxide on the substrate;

(b) providing a polysilicon layer on the gate oxide;

(c) providing a silicide layer on the polysilicon layer;

(d) selectively removing portions of the polysilicon and silicide layers to provide a gate structure, thereby causing the silicide to become metal-rich at its exposed surfaces;

(e) rapid thermally processing the silicide layer to uniformly distribute the constituents thereof;

(f) annealing the semiconductor device to provide thermal oxide on the regions of the substrate where the polysilicon and silicide layers have been removed; and

(g) providing source and drain regions in portions of the substrate corresponding to the regions of thermal oxide.

26. A method according to claim 25, wherein said step (e) comprises rapid thermally processing for approximately 2-120 seconds at a temperature range of approximately 800-1100°C.

27. A method according to claim 25, wherein said step (e) comprises rapid thermally processing for approximately 30 seconds at approximately 900°C.

28. A method aocording to claim 25, wherein said step (d) comprises providing a silicon-rich silicide and said step (e) comprises preventing the formation of metal oxide on said silicide layer during said step (f).

29. A method according to claim 25, wherein:
said step (d) comprises etching the polysilicon and silicide layers;
said step (e) comprises redistributing the constituents of the silicide so that the surface of the silicide has a uniform distribution of silicon and metal, thereby preventing the formation of metal oxide at the surface of the silicide layer during said step (f).

FIG. 1A

FIG. 1B

FIG. 1C

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | SOLID STATE TECHNOLOGY, vol. 28, no. 9, September 1985, pages 181-185, Port Washington, New York, US; S.P. MURARKA: "Recent advances in silicide technology" * Whole document * | 1 | H 01 L 21/285 <br> H 01 L 21/60 <br> H 01 L 21/90 |
| A | Idem | 2-5,8-10,12-14,16,17,20-23,26,28,29 | |
| Y | Idem | 7,11,19,25 | |
| Y | SOLID STATE TECHNOLOGY, vol. 26, no. 1, January 1983, pages 115-124; C.S. KORMAN et al.: "Etching characteristics of polysilicon, SiO2 and MoSi2 in NF3 and SF6 plasmas" * Page 122, column 1, paragraph 2 * | 7,11,19,25 | |
| A | | 2,28,29 | TECHNICAL FIELDS SEARCHED (Int. Cl.4) <br><br> H 01 L |
| A | EP-A-0 071 029 (IBM) * Page 8, line 1 - page 10, line 13 * | 1,6,11,19,21,25 | |

The present search report has been drawn up for all claims

| Place of search | Date of completion of the search | Examiner |
|---|---|---|
| THE HAGUE | 12-05-1989 | PHEASANT N.J. |